# EUROPÄISCHE PATENTSCHRIFT

(11) **EP 2 007 178 B1**
(45) Veröffentlichungstag und Bekanntmachung des Hinweises auf die Patenterteilung: **09.08.2017**
(21) Anmeldenummer: 08104210.3
(22) Anmeldetag: 02.06.2008
(51) Int. Cl.: H05K 3/40

(54) **Elektronisches Gerät mit mindestens einem elektrischen Anschlusselement und Verfahren zur Herstellung eines Anschlusselements**
Electronic device with at least one electric connected element and method for producing a connected element
Appareil électronique doté d'au moins un élément de raccordement électrique et procédé de fabrication d'un élément de raccordement

(30) Priorität: 21.06.2007 DE 102007028511
(43) Veröffentlichungstag der Anmeldung: 24.12.2008
(73) Patentinhaber: ROBERT BOSCH GMBH, 70442 Stuttgart (DE)
(72) Erfinder: Danner, Reinhold, 72108, Rottenburg (DE); Lischeck, Andre, 71665, Vaihingen/Enz (DE); Schulz, Udo, 71665, Vaihingen/Enz (DE); Proepper, Thomas, 72762, Reutlingen (DE); Barth, Heinrich, 71229, Leonberg (DE)

(56) Entgegenhaltungen:
- EP-A1- 1 737 282
- DE-A1- 1 465 852
- DE-A1- 19 709 551
- US-A- 3 969 815
- US-A- 6 084 296

## Beschreibung

Die Erfindung betrifft ein elektronisches Gerät mit mindestens einer mindestens ein elektrisches Anschlusselement aufweisenden Anschlusseinrichtung.

Die Erfindung betrifft ferner ein Verfahren zur Herstellung eines Anschlusselements eines elektronischen Geräts.

### Stand der Technik

Ein derartiges elektronisches Gerät ist zum Beispiel als ein Steuergerät einer Fahrzeugkomponente eines Kraftfahrzeugs bekannt. Das Steuergerät weist ein Gehäuse, eine im Gehäuse angeordnete Schaltungsanordnung und eine als Messerleiste ausgebildete Anschlusseinrichtung zur elektrischen Kontaktierung des Geräts, insbesondere der Schaltungsanordnung, auf. Die Messerleiste ist auf einem Schaltungsträger des Steuergeräts eingelötet oder eingepresst und besteht zumeist aus einer Anordnung von mehreren Kontaktsteckern in Form einer Steckerleiste, die von einem die Kontaktstecker überragenden Schutzkragen umgeben ist. Das Gehäuse des Steuergeräts hat eine der Kontur der Messerleiste angepasste Öffnung, durch die diese mit ihrem Schutzkragen hinausragt. Auf die Steckerleiste wird ein Gerätestecker mit entsprechend als Buchsenleiste angeordneten Kontaktbuchsen auf die Messerleiste zur elektrischen Kontaktierung des Steuergeräts im Kraftfahrzeugs aufgesteckt. Um die im Inneren des Gehäuses befindliche Schaltungsanordnung vor von außen eindringender Feuchtigkeit und Schmutz zu schützen, wird zwischen dem Schutzkragen der Messerleiste und dem Gehäuse des Steuergeräts eine Dichtung eingebracht. DE 14 65 852 offenbart ein Verfahren zur Herstellung von metallkaschierten Leiterplatten mit platierten Löchern. Dabei ist vorgesehen, dass eine freiliegende Metalifolie der Kaschierung in ein Loch der Leiterplatte mechanisch eingesickt wird.

### Offenbarung der Erfindung

Zum einfachen und kostengünstigen Aufbau des elektronischen Geräts ist vorgesehen, dass das Anschlusselement einen in ein Substrat des Geräts durch Fügen eingebrachten geprägten Kragen aus elektrisch leitfähigem Material, insbesondere Metall, aufweist, der zumindest einen Teil einer Einstecköffnung bildet. Ein derartiger Kragen ist vorzugsweise aus einem Metallblech hergestellter stanzgeprägter Kragen. Das Anschlusselement mit dem geprägten Kragen weist insbesondere eine vorzugsweise kreisförmige Grundplatte mit einem mittig ausgebildeten Durchbruch auf, wobei sich am Rand des Durchbruchs auf einer Seite der Grundplatte ein Kragen senkrecht zur Grundplatte erstreckt. Das Substrat ist als Kunststoffteil des Geräts ausgebildet.

Der Kragen weist an seinem der Grundplatte abgewandten Ende einen Vorsprung auf, der als ein den Kragen vollumfänglich umgebender Steg ausgebildet ist, so dass sich zwischen der Grundplatte und dem Steg eine Nut ergibt. Der Kragen wird zur Herstellung des Anschlusselements in das Substrat eingepresst. Durch den Vorsprung ist am Kragen eine Hinterschnittstruktur ausgebildet, der den in das Substrat eingefügten stanzgeprägten Kragen im Vollmaterial oder in einer Ausnehmung eines Substrats hält. Wird der Kragen in Vollmaterial des Substrats eingepresst, wird erst in einem zweiten Schritt die Ausnehmung, zum Beispiel durch Ausbohren des Substrats, im Innenbereich des Kragens, erstellt, wodurch die Einstecköffnung entsteht. Wird das Anschlusselement mit dem Kragen direkt in eine Ausnehmung eingepresst, so bildet diese zusammen mit dem Kragen die Einstecköffnung ohne weitere Bearbeitungsschritte. Das Anschlusselement ist ein elektrisches Anschlusselement, das insbesondere mit einer Schaltungsanordnung des elektrischen Geräts kontaktiert ist.

Weiterhin ist mit Vorteil vorgesehen, dass das Substrat als Kunststoffteil des Geräts ausgebildet ist. Das Verbinden eines stanzgeprägten Kragens mit einem Kunststoffteil ist als "Kragenfügen" bekannt. Dazu brauch der Kunststoff des Kunststoffteils nicht erhitzt werden.

Nach einer Weiterbildung der Erfindung ist vorgesehen, dass das Kunststoffteil als spritzgegossenes Kunststoffteil ausgebildet ist. Das Einpressen (Fügen) des Kragens findet insbesondere erst nach dem Spritzgussprozess statt und ist somit ein sogenanntes PMA-Verfahren (PMA: Post Moulding Assembly).

Nach einer Weiterbildung der Erfindung ist vorgesehen, dass das Substrat ein Gehäuse bildet oder mitbildet. Somit ist das Anschlusselement mit dem stanzgeprägten Kragen direkt am Gehäuse des Geräts ausgebildet.

Alternativ oder zusätzlich ist mit Vorteil vorgesehen, dass das Substrat einen Schaltungsträger mit mindestens einer Leiterbahn bildet. Der Schaltungsträger ist zum Beispiel eine Leiterplatte. Vorzugsweise ist der Schaltungsträger als spritzgegossener Schaltungsträger (MID: Moulded Interconnect Device) ausgebildet. Mittels der MID-Technik werden metallische Leiterbahnen auf spritzgegossene Kunststoffteile aufgebracht. Der Schaltungsträger ist insbesondere ein das Gehäuse bildender oder mitbildender Schaltungsträger. Die Leiterbahn ist auf einer Innen- und oder Außenseite des Gehäuses, vorzugsweise auf der Innenseite des Gehäuses, ausgebildet.

In einer vorteilhaften Ausgestaltung der Erfindung ist vorgesehen, dass der Kragen ein die Leiterbahn elektrisch kontaktierender Kragen ist. Dazu ist der Kragen insbesondere in eine Ausnehmung im Bereich der Leiterbahn eingebracht, sodass die Kragenbuchse die Leiterbahn beim Fügevorgang elektrisch kontaktiert.

Nach einer Weiterbildung der Erfindung ist vorgesehen, dass das Substrat ein Via aufweist. Ein Via ist ein durchkontaktierter Durchbruch im Schaltungsträger, der die Oberseite des Schaltungsträgers mit seiner Unterseite elektrisch verbindet. Insbesondere ist die Ausnehmung als Via ausgebildet.

Mit Vorteil ist vorgesehen, dass der Schaltungsträger bereichsweise aus dem Gehäuse herausragt. Das Anschlusselement befindet sich bevorzugt im herausragenden Teil des Schaltungsträger, sodass es von außen kontaktiert werden kann, während die Schaltungsanordnung insbesondere auf einem Teil des Schaltungsträgers ausgebildet ist, die vom Gehäuse umgeben ist.

In einer Vorteilhaften Ausgestaltung der Erfindung ist vorgesehen, dass das Gerät als Steuergerät einer Fahrzeugkomponente eines Kraftfahrzeugs ausgebildet ist. Derartige Steuergeräte sind zum Beispiel als Motorsteuergeräte eines Verbrennungsmotors oder Getriebesteuergeräte eines Getriebes des Kraftfahrzeugs ausgebildet.

Das erfindungsgemäße Verfahren zur Herstellung eines Anschlusselements für ein elektronisches Gerät, insbesondere ein vorstehend genanntes Gerät, ist dadurch gekennzeichnet, dass ein das Anschlusselement bildender, geprägter Kragen aus elektrisch leitfähigem Material, insbesondere Metall, durch Fügen in ein Substrat des Geräts eingebracht wird, wobei der Kragen in Vollmaterial des Substrats eingebracht wird und anschließend eine sich in das Innere des Kragens erstreckende Einstecköffnung erstellt wird. Das Substrat ist vorzugsweise ein Kunststoffteil, insbesondere ein spritzgegossenes Kunststoffteil des Geräts. Der Kragen des Anschlusselements ist mit Vorteil vor dem Fügevorgang durch Stanzprägen eines Metallblechs erstellt worden.

### Kurze Beschreibung der Zeichnungen

Die Erfindung wird nachfolgend in einem Ausführungsbeispiel anhand der zugehörigen Zeichnungen näher erläutert.

Es zeigen:
- Figur 1: eine schematische Darstellung eines Substrats mit geschnitten dargestellten, eingepressten Kragenbuchsen,
- Figur 2: einen Querschnitt durch ein elektronisches Gerät mit einem Kunststoffgehäuse und
- Figur 3: ein elektronisches Gerät, bei dem der Schaltungsträger bereichsweise aus dem Gehäuse herausragt.

### Ausführungsform(en) der Erfindung

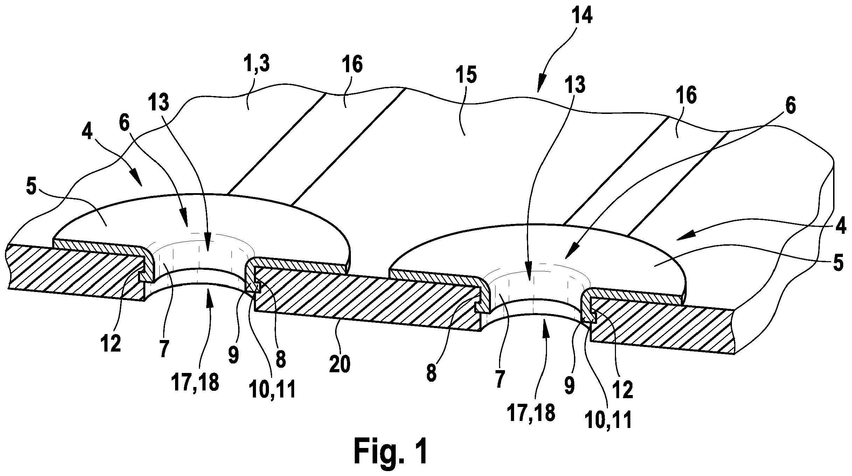

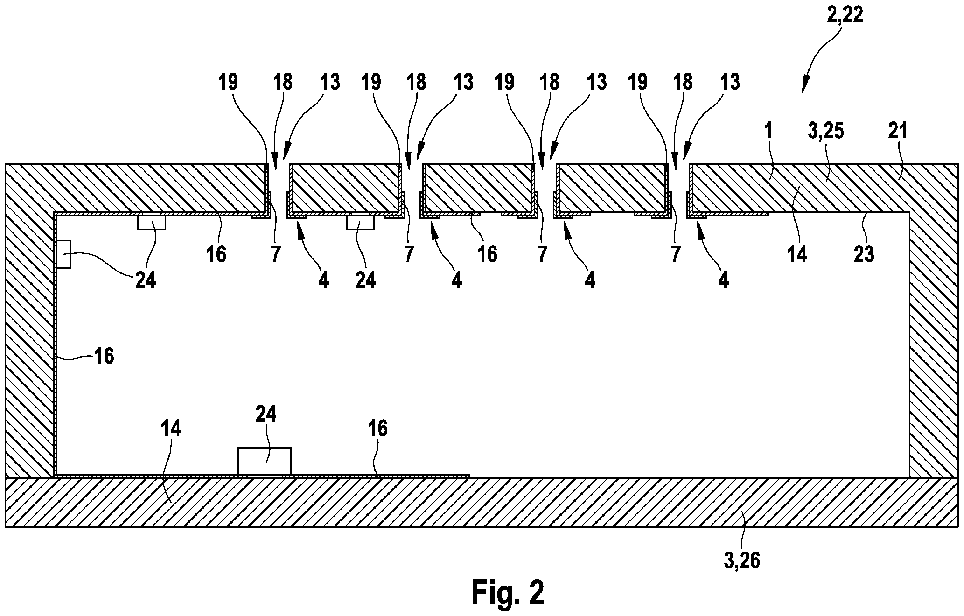

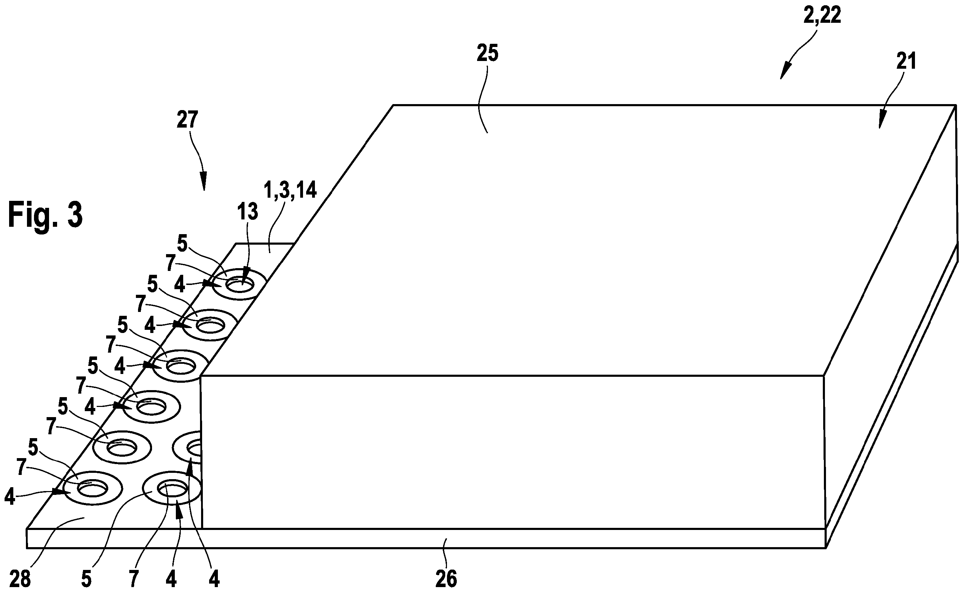

Die Figur 1 zeigt in einer Schnittdarstellung einen Ausschnitt eines Substrats 1 eines in den Figuren 2 und 3 vollständig gezeigten elektronischen Geräts 2. Das Substrat 1 ist ein Kunststoffteil 3 des elektronischen Geräts 2 und ist vorzugsweise aus spritzgegossenem Kunststoff. In dem in Figur 1 gezeigten Bereich des Substrats 1 sind zwei teilweise dargestellte Anschlusselemente 4 ausgebildet. Die Anschlusselemente 4 sind aus Metall, bevorzugt Metallblech. Der Schnitt zeigt die durch einen Fügevorgang entstandene Verbindung zwischen den Anschlusselementen 4 und dem Substrat 1. Jedes der in der Figur 3 vollständig gezeigten Anschlusselemente 4 weist dazu eine Grundplatte 5 mit einem in der Mitte der Grundplatte 5 ausgebildeten Durchbruch 6 auf. Der Durchbruch 6 ist umfänglich jeweils von einem Kragen 7 umgeben, der sich vollumfänglich senkrecht von der Grundplatte 5 aus weg erstreckt. Der Kragen 7 weist auf seiner Außenseite 8 im Bereich eines der Grundplatte 5 abgewandten Endes 9 einen Vorsprung 10 auf, der als ein den Kragen 7 vollumfänglich umgebender Steg 11 ausgebildet ist. Zwischen der Grundplatte 5 und dem Steg 11 ergibt sich eine Nut 12, wobei der Steg 11 beziehungsweise die Nut 12 als Hintergriffstruktur mit dem Kunststoffmaterial des Substrats 1 einen Hintergriff bildet. Der jeweilige Kragen 7 bildet einen Teil einer Einstecköffnung 13 des zugehörigen Anschlusselements 4. In die Einstecköffnungen 13 der Anschlusselemente 4 können nicht gezeigte Einsteckelemente eines Steckers zur elektrischen Kontaktierung eingesteckt werden.

Das Substrat 1 ist als Schaltungsträger 14 ausgebildet und weist auf seiner in Figur 1 sichtbaren Oberseite 15 zwei Leiterbahnen 16 auf. Die Leiterbahnen 16 sind parallel zueinander angeordnet und verlaufen senkrecht zu der in der Figur 1 gezeigten Schnittkante. Die Leiterbahnen 16 erstrecken sich im Bereich der Schnittkante bis zu den Kragen 7 der Anschlusselementen 4. Jedes der Anschlusselemente 4 kontaktieren die ihm zugeordnete Leiterbahn 16 mit seinem Kragen 7 und einem die jeweilige Leiterbahn abdeckenden Teil seiner Grundplatte 5.

Die Anschlusselemente 4 werden alternativ auf zwei Arten erstellt: Entweder dadurch, dass der das Anschlusselement 4 mitbildende, geprägter Kragen 7 aus Metall durch Fügen in das Substrat 1 des Geräts 2 eingebracht wird, wobei der Kragen 7 zur Ausbildung einer Einstecköffnung 13 in eine Ausnehmung 17 des Substrats 1 eingebracht wird. Dabei wird die Ausnehmung 17 in einem ersten Schritt erstellt und anschießend der Kragen 7 in die Ausnehmung 17 durch Fügen (Einpressen) eingebracht. Alternativ wird der Kragen 7 in Vollmaterial des Substrats 1 eingebracht und anschließend die sich in das Innere des Kragens 7 erstreckende Einstecköffnung 13 erstellt. Dabei wird das Anschlusselement 4 mit seinem Kragen 7 in das Vollmaterial des Kunststoffteils 2 durch Einpressen eingefügt und anschließend eine Ausnehmung 17, zum Beispiel durch Bohren, erstellt. In beiden Fällen kann die Ausnehmung 17, wie zum Beispiel in Figur 1, als Durchbruch 18 ausgebildet sein. Ein vor dem Einfügen des Kragens 7 erstellter Durchbruch 18 kann als ein in Figur 2 gezeigtes Via 19 ausgebildet sein, bei dem die Innenseite des Durchbruches 18 mit leitfähigem Material beschichtet ist. Alternativ zum Einpressen des Kragens 7 an der Oberseite 15 des Substrats 1 kann der Kragen 7 auch auf der Unterseite 20 oder je ein Kragen 7 auf der Ober- und/oder Unterseite 15, 20 zur Ausbildung des Anschlusselements 4 ausgebildet sein.

Die Figur 2 zeigt eine Schnittdarstellung durch ein Gehäuse 21 eines als Steuergerät 22 einer Fahrzeugkomponente eines Kraftfahrzeugs ausgebildetes elektronischen Geräts 2. Zumindest Teile des Gehäuses 21 sind als Substrat 1 ausgebildet. Eine der Seiten 15, 20 dieses Substrats 1 bildet eine Innenseite 23 des Gehäuses 21. Auf dieser Innenseite 23 sind elektronische Bauelemente 24 mindestens einer Schaltungsanordnung angeordnet. Das Gehäuse 21 der Figur 2 besteht zum Beispiel aus zwei Kunststoffteilen 3, die als Gehäusedeckel 25 und Gehäuseboden 26 ausgebildet sind. Der Gehäusedeckel 25 weist mehrere Anschlusselemente 4 auf, von denen vier in der Schnittdarstellung der Figur 2 dargestellt sind und die jeweils einen von der Innenseite 23 her in einen als Via 19 ausgebildeten Durchbruch 18 eingefügten Kragen 7 aufweisen. Alternativ oder zusätzlich sind (hier nicht dargestellte) Anschlusselemente 4 mit ihren Kragen 7 von außen eingepresst. Die Anschlusselemente 4 sind über ihre Kragen 7 und das Via 19 mit den Leiterbahnen 16 der Schaltungsträger 14 elektrisch verbunden und ermöglichen eine Kontaktierung der Schaltungsanordnung im Inneren des Gehäuses 21 über die Anschlusselemente 4 mit in die Anschlusselemente 4 eingebrachten Kontaktstiften eines nicht gezeigten Steckers. Bei dem in Figur 2 dargestellten elektronischen Gerät 2 bildet das Gehäuse 21 die Schaltungsträger 14 selbst an seiner Innenseite 23 aus. Dazu sind der Gehäusedeckel 25 und der Gehäuseboden 26 jeweils ein Substrat aus Kunststoff, auf dem mittels MID-Technik Leiterbahnen 16 erstellt sind. Um die Leiterbahnen 16 und die elektronischen Bauelemente 24 vor äußeren Einflüssen zu schützen, sind diese innerhalb des Gehäuses 21 angeordnet. Alternativ zur Ausbildung des Gehäuses 21 oder von Gehäuseteilen 25, 26 als Schaltungsträger 14 ist im Gehäuse 21 ein separater, zum Beispiel als Leiterplatte, ausgebildeter Schaltungsträger 14 angeordnet.

Die Figur 3 zeigt eine schematische Darstellung eines Gehäuses 21 eines ebenfalls als Steuergerät 22 ausgebildeten elektronischen Geräts 2. Das in Figur 3 dargestellte Gehäuse 21 besteht ebenfalls aus einem Gehäusedeckel 25 und einem Gehäuseboden 26, wobei der Gehäuseboden 26 als Substrat 1 ausgebildet ist. Zur Ausbildung einer Anschlusseinrichtung 27 mit mehreren Anschlusselementen 4 ragt das als Schaltungsträger 14 ausgebildete Substrat 1 aus dem Gehäuse 21 bereichsweise heraus. Bei dem in Figur 3 dargestellten elektronischen Gerät 2 ist das Substrat 1 gleichzeitig als Gehäuseboden 26 ausgebildet, alternativ ist der Schaltungsträger 14 kein Teil des Gehäuses 21 und ragt mit einem anderen Bereich aus dem Gehäuse 21 heraus. Auf dem herausragenden Teil 28 des Schaltungsträgers 1 sind mehrere Anschlusselemente 4 die über nicht dargestellte Leiterbahnen 16 mit einer ebenfalls nicht dargestellten Schaltungsanordnung im Gehäuse 21 kontaktiert.

## Patentansprüche

1. Elektronisches Gerät mit mindestens einer mindestens ein elektrisches Anschlusselement aufweisenden Anschlusseinrichtung, wobei das Anschlusselement (4) einen in ein Substrat (1) des Geräts (2) durch Fügen eingebrachten geprägten Kragen (7) aus elektrisch leitfähigem Metall aufweist, der zumindest einen Teil einer Einstecköffnung (13) bildet, wobei das Anschlusselement (4) eine kreisförmige Grundplatte (5) mit einem mittig ausgebildeten Durchbruch (6) aufweist, wobei sich am Rand des Durchbruchs (6) der Kragen (7) auf einer Seite der Grundplatte (5) senkrecht zur Grundplatte (5) erstreckt, wobei dass das Substrat (1) als Kunststoffteil (3) des Geräts (2) ausgebildet ist, **dadurch gekennzeichnet dass** der Kragen (7) an seinem der Grundplatte (5) abgewandten Ende (9) einen Vorsprung (10) aufweist, der als ein den Kragen (7) vollumfänglich umgebender Steg (11) ausgebildet ist, so dass sich zwischen der Grundplatte (5) und dem Steg (11) eine Nut (12) ergibt, und wobei der Vorsprung (10) den in das Substrat (1) eingefügten stanzgeprägten Kragen (7) im Vollmaterial des Substrats (1) hält.

2. Gerät nach Anspruch 1, **dadurch gekennzeichnet, dass** das Kunststoffteil (3) als spritzgegossenes Kunststoffteil (3) ausgebildet ist.

3. Gerät nach einem der vorhergehenden Ansprüche, **dadurch gekennzeichnet, dass** das Substrat (1) ein Gehäuse (21) bildet oder mitbildet.

4. Gerät nach einem der vorhergehenden Ansprüche, **dadurch gekennzeichnet, dass** das Substrat (1) einen Schaltungsträger (14) mit mindestens einer Leiterbahn (16) bildet.

5. Gerät nach einem der vorhergehenden Ansprüche, **dadurch gekennzeichnet, dass** der Kragen (7) ein die Leiterbahn (16) elektrisch kontaktierender Kragen (7) ist.

6. Gerät nach einem der vorhergehenden Ansprüche, **dadurch gekennzeichnet, dass** das Substrat (1) ein Via (19) aufweist.

7. Gerät nach einem der vorhergehenden Ansprüche, **dadurch gekennzeichnet, dass** der Schaltungsträger (14) bereichsweise aus dem Gehäuse (20) herausragt.

8. Gerät nach einem der vorhergehenden Ansprüche, **gekennzeichnet durch** die Ausbildung als Steuergerät einer Fahrzeugkomponente eines Kraftfahrzeugs.

9. Verfahren zur Herstellung eines Anschlusselements für ein elektronisches Gerät nach mindestens einem der vorhergehenden Ansprüche, **dadurch gekennzeichnet, dass** ein das Anschlusselement bildender, geprägter Kragen aus elektrisch leitfähigem Material, insbesondere Metall, durch Fügen in ein Substrat des Geräts eingebracht wird, **dadurch gekennzeichnet dass** der Kragen in Vollmaterial des Substrats eingebracht wird und anschließend eine sich in das Innere des Kragens des erstreckende Einstecköffnung erstellt wird.

## Claims

1. Electronic device comprising at least one connection device which has at least one electrical connection element, wherein the connection element (4) has a shaped collar (7) which is introduced into a substrate (1) of the device (2) by joining and is composed of electrically conductive metal and forms at least a portion of an insertion opening (13), wherein the connection element (4) has a circular base plate (5) with a centrally formed aperture (6), wherein, at the edge of the aperture (6), the collar (7) extends perpendicular to the base plate (5) on one side of the base plate (5), wherein that the substrate (1) is in the form of a plastic part (3) of the device (2), **characterized in that** the collar (7) has, at its end (9) which is averted from the base plate (5), a projection (10) which is in the form of a web (11) which surrounds the entire circumference of the collar (7), so that a groove (12) is produced between the base plate (5) and the web (11), and wherein the projection (10) holds the stamped collar (7) which is inserted into the substrate (1) in the solid material of the substrate (1).

2. Device according to Claim 1, **characterized in that** the plastic part (3) is in the form of an injection-moulded plastic part (3).

3. Device according to either of the preceding claims, **characterized in that** the substrate (1) forms or jointly forms a housing (21).

4. Device according to one of the preceding claims, **characterized in that** the substrate (1) forms a circuit carrier (14) comprising at least one conductor track (16).

5. Device according to one of the preceding claims, **characterized in that** the collar (7) is a collar (7) which makes electrical contact with the conductor track (16).

6. Device according to one of the preceding claims, **characterized in that** the substrate (1) has a via (19).

7. Device according to one of the preceding claims, **characterized in that** the circuit carrier (14) protrudes out of the housing (20) in regions.

8. Device according to one of the preceding claims, **characterized by** the design as a control device of a vehicle component of a motor vehicle.

9. Method for producing a connection element for an electronic device according to at least one of the preceding claims, **characterized in that** a shaped collar which forms the connection element and is composed of electrically conductive material, in particular metal, is introduced into a substrate of the device by joining, **characterized in that** the collar is introduced into the solid material of the substrate and an insertion opening which extends into the interior of the collar is then created.

## Revendications

1. Appareil électronique comportant au moins un dispositif de connexion comportant au moins un élément de connexion électrique, dans lequel l'élément de connexion (4) comporte un collier (7) façonné dans un substrat (1) de l'appareil (2) en étant introduit par assemblage, constitué d'un métal électriquement conducteur, qui fait au moins partie d'une ouverture d'enfichage (13), dans lequel l'élément de connexion (4) comporte une plaque de base circulaire (5) présentant une traversée (6) réalisée en son centre, dans lequel le collier (7) s'étend sur le bord de la traversée (6) sur une face de la plaque de base (5), perpendiculairement à la plaque de base (5), dans lequel en ce que le substrat (1) est réalisé sous la forme d'une pièce en matière plastique (3) de l'appareil (2), **caractérisé en ce que** le collier (7) présente à son extrémité (9) tournée en sens opposé à la plaque de base (5) une protubérance (10) qui est réalisée sous la forme d'une barre (11) entourant entièrement le collier (7) de manière à former ainsi une rainure (12) entre la plaque de base (5) et la barre (11), et dans lequel la protubérance (10) maintient le collier (7) façonné par estampage inséré dans le substrat (1) au sein du matériau massif du substrat (1).

2. Appareil selon la revendication 1, **caractérisé en ce que** la pièce en matière plastique (3) est réalisée sous la forme d'une pièce en matière plastique (3) moulée par injection.

3. Appareil selon l'une quelconque des revendications précédentes, **caractérisé en ce que** le substrat (1) forme ou contribue à la formation d'un boîtier (21).

4. Appareil selon l'une quelconque des revendications précédentes, **caractérisé en ce que** le substrat (1) forme un support de circuit (14) présentant au moins une piste conductrice (16).

5. Appareil selon l'une quelconque des revendications précédentes, **caractérisé en ce que** le collier (7) est un collier (7) en contact électrique avec la piste conductrice (16).

6. Appareil selon l'une quelconque des revendications précédentes, **caractérisé en ce que** le substrat (1) présente un trou traversant (19).

7. Appareil selon l'une quelconque des revendications précédentes, **caractérisé en ce que** le support de circuit (14) fait saillie par endroits hors du boîtier (20).

8. Appareil selon l'une quelconque des revendications précédentes, **caractérisé en ce qu'**un composant de véhicule d'un véhicule automobile est réalisé sous la forme d'un appareil de commande.

9. Procédé de fabrication d'un élément de connexion destiné à un appareil électronique selon au moins l'une des revendications précédentes, **caractérisé en ce qu'**un collier façonné formant l'élément de connexion et constitué d'un matériau électriquement conducteur, notamment de métal, est introduit par assemblage dans un substrat de l'appareil, **caractérisé en ce que** le collier est introduit dans le matériau massif du substrat et ensuite une ouverture d'enfichage s'étendant à l'intérieur du collier est réalisée.
